# EUROPÄISCHE PATENTANMELDUNG

(11) **EP 4 043 620 A1**
(43) Veröffentlichungstag der Anmeldung: **17.08.2022**
(21) Anmeldenummer: 22166112.7
(22) Anmeldetag: 18.05.2015
(51) Int. Cl.: C30B 25/02, C30B 25/18, C30B 29/52, C30B 29/10, C30B 29/48, C09K 11/66, H01L 21/02, C30B 29/40

(54) **VERFAHREN ZUM ABSCHEIDEN EINER KRISTALLSCHICHT BEI NIEDRIGEN TEMPERATUREN, INSBESONDERE EINER PHOTOLUMINESZIERENDEN IV-IV-SCHICHT AUF EINEM IV-SUBSTRAT, SOWIE EIN EINE DERARTIGE SCHICHT AUFWEISENDES OPTOELEKTRONISCHES BAUELEMENT**

(30) Priorität: 13.06.2014 DE 102014108352
(62) Teilanmeldung aus: 15726035.7
(71) Anmelder: Forschungszentrum Jülich GmbH, 52425 Jülich (DE)
(72) Erfinder: Grützmacher, Detlev, 52382 Niederzier (DE); Wirths, Stephan, 52062 Aachen (DE); Buca, Dan Mihai, 52428 Jülich (DE); Mantl, Siegfried, 52428 Jülich (DE)
(74) Vertreter: Grundmann, Dirk

(57) **Zusammenfassung**

Die Erfindung betrifft ein Verfahren zum monolithischen Abscheiden einer einkristallinen, bei Anregung leuchtenden, aus mehreren Elementen der IV-Haupt-gruppe bestehende IV-IV-Schicht, insbesondere einer GeSn oder Si-GeSn Schicht mit einer Versetzungsdichte kleiner 10⁶ cm⁻² auf einem IV-Substrat, insbesondere einem Silizium- oder Germanium-Substrat mit folgenden Schritten: Bereitstellen eines Hydrids eines ersten IV-Elementes (A) beispielsweise Ge₂H₆ oder Si₂H₆; Bereitstellen eines Halogenids eines zweiten IV-Elementes (B) beispielsweise SnCl₄; Aufheizen des Substrates auf eine Substrattemperatur, die geringer ist als die Zerlegungstemperatur des reinen Hydrids oder eines daraus gebildeten Radikals und ausreichend hoch ist, dass Atome des ersten Elementes (A) und des zweiten Elementes (B) in kristalliner Ordnung in die Oberfläche eingebaut werden, wobei die Substrattemperatur insbesondere in einem Bereich zwischen 300 °C und 475 °C liegt; Erzeugen eines Trägergasstroms aus einem inerten Trägergas, insbesondere N₂, Ar, He, welches insbesondere kein H₂ ist; Transportieren des Hydrids und des Halogenids sowie daraus entstandene Zerfallsprodukte zur Oberfläche bei einem Totaldruck von maximal 300 mbar; Abscheiden der IV-IV-Schicht oder einer aus gleichartigen IV-IV-Schichten bestehende Schichtenfolge mit einer Dicke von mindestens 200 nm, wobei die abgeschiedene Schicht insbesondere eine Si_{y}Ge_{1-x-y}Sn-Schicht ist, mit x > 0,08 und y ≤ 1.

## Beschreibung

Die Erfindung betrifft ein Verfahren zum Abscheiden eines insbesondere binären, ternären oder quaternären Halbleiterkristalls, welcher als Folge eines direkten elektronischen Bandübergangs bei einer Anregung, beispielsweise durch Anlegen einer Spannung oder durch Einkoppeln von Licht im sichtbaren, infraroten oder ultravioletten Licht leuchtet.

Die Erfindung betrifft darüber hinaus ein optoelektronisches Bauelement, welches eine aus einem derartigen Kristall bestehende Schicht aufweist, sowie einen integrierten Schaltkreis, der ein derartiges Bauelement aufweist.

Die Erfindung betrifft darüber hinaus das Abscheiden einer Kristallschicht eines Kristalls bei niedrigen Temperaturen, insbesondere jenseits seines thermodynamischen Gleichgewichtes.

Aus "DEPOSITION OF HIGH QUALITY GaAs FILMS AT FAST RATES IN THE LP-CVD SYSTEM", Journal of crystal grows 94 (1989) 607-612 ist das Abscheiden von Galliumarsenid-Schichten vorbekannt. Gallium wird in Form eines Chlorides und Arsen in Form eines Hydrides in eine Prozesskammer eingeleitet. Die Wachstumsrate nimmt mit sinkender Temperatur und mit sinkendem Totaldruck ab. Die Abhängigkeit der Wachstumsrate vom Totaldruck hat bei etwa 100 mbar ein Minimum und steigt zu tieferen Totaldrücken bis 10 mbar um mehr als einen Faktor 10 an.

Die Mehrzahl der technologisch verwendeten Halbleiterbauelemente und insbesondere integrierten Schaltkreise, insbesondere Logikschaltkreise oder in Mikroprozessoren verwendete Schaltkreise werden mit der Siliziumtechnologie hergestellt. Zur Verwendung kommt ein Siliziumsubstrat, auf dem dotierte oder undotierte Siliziumschichten bzw. Siliziumoxidschichten abgeschieden werden. Trotz der voneinander verschiedenen Gitterkonstanten ist es auch möglich, andere IV-IV Legierungen kristallin auf einem Siliziumkristall abzuscheiden, beispielsweise Germanium oder Germaniumzinn. Ein technologischer Nachteil bislang hergestellter IV-IV Kristalle ist das Fehlen eines direkten elektronischen Bandübergangs. Sowohl Silizium als auch Germanium, aber auch thermodynamisch stabiles Germaniumzinn oder Siliziumzinn besitzen keinen direkten Bandübergang, der zur Fertigung von optisch aktivierbaren Bauelementen, beispielsweise LEDs oder Laser, tauglich ist.

Es wird vermutet, dass eine unverspannte Germaniumzinn-Legierung als Kristall außerhalb des thermodynamischen Gleichgewichtes, nämlich bei Zinnkonzentrationen von mindestens etwa 20 % einen direkten Bandübergang haben könnte. Die Gleichgewichtszinnkonzentration in einer Germaniumzinn-Legierung liegt aber bei weniger als 1 %. Es wird vermutet, dass eine Zunahme der Zinnkonzentration unter Bildung eines thermodynamisch metastabilen Kristalls zu einer Absenkung des Leitungsbandes im Bereich des Γ-Tals führen würde, die stärker ist als die Absenkung des Leitungsbandes im L-Tal. Im Γ-Tal würde sich dann ein direkter Bandübergang ausbilden, der dem Kristall die gewünschten optischen Eigenschaften verleihen würde.

In "SiGeSn growth studies using reduced pressure chemical vapor deposition towards optoelectronic applications" in Thin Solid Films 2013 (S. Wirths, et al., Thin Solid Films (2013), http://dx.doi.org/10.1016/j.tsf.2013.10.078) wird das Abscheiden von Germaniumzinn- bzw. Siliziumgermaniumzinn-Schichten auf Siliziumsubstraten bzw. auf Germaniumbufferschichten beschrieben. Die dort abgeschiedenen, 45 nm bzw. 65/100 nm dicken Schichten mit einem Sn-Anteil von maximal 11 % zeigten keine Lumineszens. Es wurde ein pseudomorphes Wachstum gefunden. Die dort beschriebenen Experimente wurden bei Substrattemperaturen zwischen 350 °C und 475 °C durchgeführt. Als Prozessgase wurden Si₂H₆ (60 Pa), Ge₂H₆ (120 Pa) und SnCl4 (0,6 Pa) verwendet.

In "Reduced Pressure CVD Growth of Ge and Ge1-xSnx Alloys" (ESC Journal of Solid State Science and Technology, 2(5) N99-N102 (2013)) wird der experimentelle Aufbau eines CVD-Reaktors beschrieben, mit dem Germaniumschichten auf Siliziumsubstraten bzw. Germaniumzinn-Schichten auf Siliziumsubstraten abgeschieden werden können.

Zum Stand der Technik gehören darüber hinaus auch folgende Veröffentlichungen, die das Abscheiden nicht lumineszierender GeSn-Schichten beschreiben:
"Band engineering and growth of tensile strained Ge/(Si)GeSn heterostructures for tunnel field effect transistors" (Applied Physics Letters 102, 192103 (2013)),
"Tensely strained GeSn alloys as optical gain media" (Applied Physics Letters 103, 192110 (2013)),
"Low temperature RPCVD epitaxial growth of Si1-xGex using Si2H6 and Ge2H6" (Solid-State Electronics 83 (2013) 2-9),
"Epitaxial Growth of Ge1-xSnx by Reduced Pressure CVD Using SnCl4 and Ge2H6" (ECS Transactins, 50 (9) 885-893 (2012) © The Electrochemical Society).

Eine Vorrichtung zum Abscheiden von Silizium und Germanium enthaltenden Schichten bzw. Schichtenfolgen wird in der DE 10 2004 034 103 A1 beschrieben. Die Verwendung von Radikalen in einem CVD-Prozess ist aus der US 6,200,893 vorbekannt.

Der Erfindung liegt die Aufgabe zugrunde, Kristalle bei niedrigen Temperaturen, insbesondere außerhalb ihres thermodynamischen Gleichgewichtes abzuscheiden, insbesondere optisch aktive bzw. aktivierbare IV-Halbleiterschichten abzuscheiden, um die monolithische Integration optisch aktiver Bauelemente auf Siliziumsubstraten zu ermöglichen.

Gelöst wird die Aufgabe durch die in den Ansprüchen angegebene Erfindung.

Der erste Aspekt der Erfindung betrifft ein Verfahren zum Abscheiden einer kristallinen Halbleiterschicht. Die Halbleiterschicht soll zumindest aus einem oder mehreren Elementen bestehen. Die ein oder mehreren Elemente werden als Bestandteile gasförmiger Ausgangsstoffe zusammen mit einem inerten Trägergas in eine Prozesskammer eines CVD-Reaktors eingespeist. Der erste gasförmige Ausgangsstoff kann ein Hydrid sein, beispielsweise CH₃, SiH₄, Si₂H₆, AsH₃, PH₃ oder NH₃. Der zweite gasförmige Ausgangsstoff kann ein Chlorid sein, beispielsweise SiCl4, GeCl₄, CCl₄, SnCl₄, GaCl₄, InCl₄ oder AlCl₄. Das Trägergas kann N₂, Ar, He sein, sollte aber kein H₂ sein. Die Vorrichtung zur Durchführung des Verfahrens besitzt bevorzugt ein Gaseinlassorgan, beispielsweise in Form eines Showerheads. Dieser besitzt eine oder mehrere Gasverteilkammern, die jeweils eine Vielzahl von Gasaustrittsöffnungen aufweisen, die in eine Prozesskammer münden. Durch die Gasaustrittsöffnungen können die Prozessgase in die Prozesskammer strömen. Das Gaseinlassorgan wird gekühlt um eine dortige Vorzerlegung der Ausgangsstoffe zu vermeiden. Der Abscheidungsprozess erfolgt im Niedrigdruckbereich, also bei Drucken niedriger als 300 mbar, niedriger als 200 mbar, niedriger als 100 mbar oder bevorzugt bei 60 mbar. Aus dem ersten Ausgangsstoff werden Radikale erzeugt. Dies kann in der in der Literatur beschriebenen Weise erfolgen, beispielsweise durch ein Plasma, einen Heißdraht oder eine Hochfrequenzaktivierung. Bevorzugt werden die Radikale aber dadurch erzeugt, dass das erste Prozessgas beim Eintritt in das Gaseinlassorgan bzw. in die Prozesskammer von einem hohen Druck, der oberhalb des Atmosphärendrucks liegt, zu einem niedrigen Druck entspannt wird, wobei der niedrige Druck dem Totaldruck in der Prozesskammer entspricht, der weniger als 300 mbar beträgt. Beispielsweise können Ge₂H₆ oder Si₂H₆ in German- oder Silanradikale (GeH₃* oder SiH₃*) zerfallen. Wegen des geringen Partialdrucks in der Prozesskammer reduziert sich die Rückreaktionsrate, so dass das in die Prozesskammer eingespeiste Trägergas Radikale zur Oberfläche eines auf eine Substrattemperatur aufgeheizten Halbleitersubstrats transportiert. Da kein H₂ oder nur ein Minimum an H₂ in der Gasphase vorhanden ist, fehlt der erforderliche Reaktionsparameter, um GeH₄ bzw. SiH₄ zu bilden. Es entstehen somit hochverdünnte Radikale in der Gasphase. Die Substrattemperatur ist niedriger als die Zerlegungstemperatur des reinen Radikals. Dies hat zur Folge, dass ohne die Beimischung des Chlorides nur ein verschwindend geringes Wachstum von 1 nm/h und weniger stattfinden würde. Erfindungsgemäß wird aber zusammen mit den Radikalen das Chlorid zur Substratoberfläche transportiert. Dort findet eine erste Reaktion zwischen den Radikalen und den Chloriden statt. Bei dieser exothermen Reaktion wird Reaktionswärme frei, die zu einer lokalen Temperaturerhöhung an der Oberfläche der Schicht bzw. des Substrates führt. Dort wo die erste Reaktion stattfindet, besitzt die Oberfläche somit eine Temperatur, die zur Zerlegung des ersten Ausgangsstoffes und insbesondere des daraus dissoziierten Radikals ausreicht. In der ersten Reaktion entsteht ein gasförmiges Reaktionsprodukt, das mit dem Trägergas abgeführt wird. Als nichtgasförmiges Reaktionsprodukt verbleiben die ersten und zweiten Elemente an der Oberfläche. Bei der zweiten Reaktion, die durch die Reaktionswärme der ersten Reaktion in Gang gesetzt wird, zerfällt das Radikal in ein flüchtiges Reaktionsprodukt, das mit dem Trägergas abtransportiert wird, und in das erste Element. Als Folge der beiden zeitgleich stattfindenden Reaktionen sind Atome des ersten Elementes und zweiten Elementes an der Substratoberfläche adsorbiert. Das Substrat liegt auf einem von unten, beispielsweise durch eine Lampenheizung beheizten Suszeptor auf. Dieser ist etwa 1 bis 2 cm von der Gasaustrittsfläche des Showerheads beabstandet. Die Substrattemperatur liegt unterhalb des zuvor genannten oberen Grenzwertes, so dass das reine Hydrid oder das reine Radikal an der Oberfläche nicht zerfallen kann, sondern nur durch die zuvor genannte Kettenreaktion in seine Bestandteile zerlegt wird. Die Substrattemperatur ist ausreichend hoch (sie liegt bevorzugt im Bereich zwischen 300 °C und 450 °C) um eine Oberflächenbeweglichkeit der aus den beiden chemischen Reaktionen hervorgegangenen nichtflüchtigen Reaktionsprodukte zu gewährleisten. Einen signifikanten Beitrag zur Steigerung der Oberflächenmobilität liefert die Reaktionswärme der ersten Reaktion zwischen den Radikalen und den Halogeniden. Die an der Oberfläche adsorbierten Atome der ein oder mehreren Elemente können sich somit für eine kurze Zeit und Strecke geringfügig über die Oberfläche bewegen, um energetisch günstige Einbauplätze in das Kristallgitter zu finden. Die lokale Oberflächentemperatur ist derart hoch, dass die Atome des ersten Elementes und des zweiten Elementes in kristalliner Ordnung in der Oberfläche eingebaut werden. Da die Oberfläche der Schicht wärmer ist als das Substrat, die Oberfläche also eine höhere Temperatur aufweist als die Substrattemperatur, wird eine ansonsten bei der Substrattemperatur auftretende Oberflächenrauhigkeit unterdrückt. Eine Amorphisierung findet nicht statt. Bei den Experimenten, über die in der eingangs zitierten Literatur berichtet wird, wurden dünne SiGeSn-Schichten auf Ge-Schichten abgeschieden. Unter den dortigen Prozessbedingungen wurden relativ dünne (45 nm bzw. 85 nm dicke) Schichten auf Silizium-Substraten bzw. Germanium-Pseudo-Substraten abgeschieden. Aufgrund des relativ großen Unterschiedes der Kristallgitterkonstante eines GeSn-Kristalls zu einem Ge-Kristall tritt bei der Abscheidung eine tetragonale Verzerrung des Kristalls des aufgewachsenen Materials auf. Die planare Gitterkonstante senkrecht zur Wachstumsrichtung passt sich der kubischen Gitterkonstante des Substrates an. Die senkrechte Gitterkonstante, die sich parallel zur Wachstumsrichtung erstreckt, vergrößert sich. Bei den eingangs genannten Voruntersuchungen wurde eine mit zunehmender Schichtdicke rauere Oberfläche beobachtet. Es wurde die Bildung von Gitterfehlanpassungsversetzungen an der Grenzfläche zum dort verwendeten Si-Substrat beobachtet sowie eine hohe Dichte von Fadenversetzungen, die sich durch die komplette 85 nm-Schicht bis zur Oberfläche ziehen. Bei den verwendeten niedrigen Wachstumstemperaturen für das GeSn-Wachs-tum ist die Oberflächenmobilität der auf der Oberfläche adsorbierten Moleküle der gasförmigen Ausgangsstoffe bzw. deren Zerlegungsprodukte stark reduziert, was zu einer großen Rauigkeit und letztendlich zu der beobachteten Amorphisierung führt. Überraschenderweise hat sich herausgestellt, dass mit Hilfe der erfindungsgemäßen Radikalunterstützten Wachstumsmethode der ansonsten erwartete "epitaxial breakdown" insbesondere bei der Verwendung einer Ge-Bufferschicht nicht eintritt. Bei Schichtdicken oberhalb einer kritischen Schichtdicke beginnt eine Relaxation der Schicht, die bis zu 80 % oder mehr anwachsen kann und bevorzugt über 80 % anwächst. Die Dichte von Fadenversetzungen reduziert sich auf Werte von kleiner 10⁶ cm⁻² bzw. kleiner 10⁵ cm⁻². Die Gitterfehlanpassungsversetzungen sind auf einen kleinen Bereich (10 nm bis 20 nm) nahe der Grenzfläche lokalisiert. Die ansonsten erwarteten Fadenversetzungen oder Schraubenversetzungen konnten nicht festgestellt werden. Signifikante Gitterfehlanpassungsversetzungen wurden nur in dem Bereich bis zu 10 nm bis 20 nm angrenzend an die Grenzfläche beobachtet, wobei auch Versetzungen in der Ge-Bufferschicht unmittelbar angrenzend an die Grenzschicht beobachtet wurden. Der Relaxionsmechanismus wurde insbesondere bei Schichten, die mindestens eine Schichtdicke von 200 nm aufweisen beobachtet, die auf eine defektarme Ge-Bufferschicht abgeschieden wurden, wobei die Ge-Bufferschicht auf ein Si(001)-Substrat abgeschieden worden ist. Sowohl das Abscheiden der Bufferschicht als auch das Abscheiden der IV-IV-Schicht kann in einem Gesamtprozess in aufeinanderfolgenden Prozessschritten in einer Prozesskammer eines CVD-Reaktors ohne zwischenzeitiges Öffnen der Prozesskammer stattfinden. Wesentlich ist ein Schichtwachstum von mindestens 200 nm, bevorzugt von mind. 300 nm. Das erfindungsgemäße Verfahren benutzt zur lokalen Erwärmung der Schichtoberfläche die Reaktionswärme einer reaktiven Gasquelle (Radikale). Es findet ein Kristallwachstum im Nichtgleichgewichtszustand statt. Der Nichtgleichgewichtszustand wird gewissermaßen eingefroren, da als Folge eines hohen Temperaturgradienten die durch die chemische Reaktion erzeugte lokale Wärme in kurzer Zeit in dem Kristall abgeführt wird. Als erster gasförmiger Ausgangsstoff kann eines der oben genannten Hydride der V-Haupt-gruppe verwendet werden. Als zweiter gasförmiger Ausgangsstoff wird bevorzugt eines der oben genannten Halogenide der III-Hauptgruppe verwendet. Es ist auch vorgesehen, Hydride der Elemente der VI-Hauptgruppe und Halogenide, insbesondere Chloride von Elementen der II-Hauptgruppe zu verwenden. Besonders bevorzugt wird das Verfahren aber verwendet, um IV-IV Schichten auf IV-IV-Substraten abzuscheiden. Bevorzugt beinhalten die beiden gasförmigen Ausgangsstoffe zwei voneinander verschiedene Elemente, beispielsweise Ge und Sn. Als erster gasförmiger Ausgangsstoff wird dann Si₂H₆, gegebenenfalls auch SiH₄ oder Ge₂H₆, gegebenenfalls auch GeH₄ verwendet. Als zweiter Ausgangsstoff wird ein Halogenid eines Elementes der IV-Hauptgruppe verwendet, beispielsweise ein Bromid, ein Jodid oder ein Chlorid. Bevorzugt wird SnCl₄ verwendet. SnCl₄ und Ge₂H₆ bzw. Si₂H₆ werden durch ein gekühltes Gaseinlassorgan in eine Prozesskammer eingeleitet. Der Totaldruck in der Prozesskammer hat einen Wert, bei dem Ge₂H₆, bevorzugt aber auch Si₂H₆ überwiegend in Radikale zerfallen ist. Diese Radikale werden zusammen mit dem Chlorid mittels eines inerten Trägergases, insbesondere N₂, bevorzugt kein H₂, zur Substratoberfläche transportiert. Die Moleküle adsorbieren an der Oberfläche. Es findet eine exotherme Oberflächenreaktion zwischen dem Radikal und dem Chlorid statt, bei der HCl und Energie frei wird. Die Energie aktiviert weitere Zerfälle des Radikals und eine lokale Erwärmung der Oberfläche, so dass die Ge-Atome und Sn-Atome eine ausreichende Oberflächenmobilität besitzen, um einkristallin in das Kristall eingebaut zu werden. Es wurde beobachtet, dass bereits bei einem Sn-Anteil von mehr als 8 % photolumineszierende Schichten entstehen, wenn die Voraussetzung zur Bildung von Radikalen vorliegen und eine Schichtdicke oberhalb einer kritischen Dicke abgeschieden wird. Die Veränderung des Bandübergangs weg von einem indirekten Bandübergang hin zu einem direkten Bandübergang tritt bei einem Sn-Anteil in Ge bzw. SiGe abhängig von der Verspannung bei mehr als 8 %, insbesondere bei mehr als 10 % auf. Der maximal erforderliche Sn-Anteil für unverspanntes GeSn liegt bei 14 % bzw. bei 20 %. Das Hydrid, insbesondere das Ge₂H₆ besitzt in der Prozesskammer einen Partialdruck im Bereich zwischen 60 Pa und 120 Pa. Das Halogenid, insbesondere das SnCl₄ wird mit einem derartigen Fluss in die Prozesskammer eingespeist, dass der Partialdruck etwa zwischen 0,1 % und 5 % des Partialdrucks des Hydrides liegt, insbesondere im Bereich zwischen 0,03 Pa und 1,25 Pa. Das Abscheiden der optisch aktiven Schicht erfolgt bevorzugt auf einer relaxierten Ge-Bufferschicht. Bei Wachstumsraten zwischen 10 nm/min und 50 nm/min. Die beiden gasförmigen Ausgangsstoffe können aber auch dieselben Elemente, beispielsweise C, Si, Ge enthalten. Ein erster gasförmiger Ausgangsstoff kann somit ein Kohlenwasserstoff, ein Siliziumwasserstoff oder ein Germaniumwasserstoff sein. Der zweite gasförmige Ausgangsstoff kann ein Kohlenstoffchlorid, ein Siliziumchlorid oder ein Germaniumchlorid sein. Ein CH₃-Radikal kann bei dieser Variante der Erfindung beispielsweise mit CCl₄ an der Oberfläche des Substrates reagieren und eine Diamantschicht bilden. Es lassen sich somit Elementhalbleiter, beispielsweise Silizium- oder Germanium-Halbleiter bei niedrigen Temperaturen abscheiden.

Die Erfindung betrifft darüber hinaus ein Bauelement mit einer Schichtstruktur, die eine mit dem oben genannten Verfahren abgeschiedene Schicht, insbesondere GeSn- oder SiGeSn-Schicht aufweist. Der Sn-Anteil liegt bei mindestens 8 %, bevorzugt mindestens 10 %, oder in einem Bereich von 8 % bis 20 %, bevorzugt 10 % bis 14 %. Die Schichtdicke ist größer als 200 nm, bevorzugt größer als 300 nm. Die Versetzungsdichte innerhalb des Schichtvolumens, also außerhalb eines 10 nm bis 20 nm an die Grenzfläche zur Bufferschicht angrenzenden Bereiches, bei kleiner 10⁶ cm⁻² bzw. 10⁻⁵ cm⁻². Lediglich in dem unmittelbar an die Bufferschicht angrenzenden Bereich besitzt die Schicht eine höhere Versetzungsdichte. Im Bereich 10 nm bis 20 nm nahe der Grenzfläche befinden sich insbesondere stufenförmige Versetzungen, jedoch nur in geringem Umfang schraubenförmige oder fadenförmige Versetzungen. Die Schicht besitzt einen direkten Bandübergang mit einer Energie von etwa 450 meV und ist in der Lage, nach optischer oder elektrischer Anregung zu photolumineszieren.

Die Erfindung betrifft darüber hinaus einen integrierten Schaltkreis, insbesondere MOS-Schaltkreise, mit einer monolithisch aufgebauten integrierten Schaltung, wobei als Substrat insbesondere ein Si-Substrat verwendet wird. Erfindungsgemäß ist auf das Substrat oder auf eine auf das Substrat aufgebrachte Bufferschicht eine GeSn- oder GeSn enthaltende Schichtenfolge aufgebracht, wobei insbesondere vorgesehen ist, dass die Schichtenfolge eine GeSn-Schicht aufweist, die zwischen zwei SiGeSn-Schichten angeordnet ist. Ein derartiger integrierter Schaltkreis besitzt eine Vielzahl von bekannten Bauelementen, beispielsweise Transistoren, Kondensatoren sowie elektrisch leitenden Schichten und elektrisch isolierenden Schichten. Erfindungsgemäß ist der integrierte Schaltkreis um optisch aktive Bauelemente ergänzt worden, die monolithisch auf demselben Substrat abgeschieden werden, so dass in einem derartigen integrierten Schaltkreis nicht nur Strom, sondern auch Licht zur Informationsverbreitung verwendet werden kann.

Die Erfindung betrifft darüber hinaus ein Verfahren zum Abscheiden einer einkristallinen, bei Anregung leuchtenden Schicht aus Elementen der III- und V-Hauptgruppe. Eine III-V-Schicht, insbesondere GaN-Schicht wird auf einem Substrat, bspw. ein Saphirsubstrat, einem Siliziumsubstrat oder einem III-V-Substrat abgeschieden. Die Schicht kann eine Versetzungsdichte <10⁶cm⁻² besitzen. Das Verfahren wird analog der oben angegebenen Verfahrensschritte betreffend das Abscheiden einer IV-IV-Schicht durchgeführt. Zunächst ein Hydrid des fünften Hauptgruppenelementes bereitgestellt, bei diesem Hydrid kann es sich um NH₃ oder NH₂R handeln, wobei R ein organischer Rest, bspw. C₄H₉ (Tertiärbutylat) ist. Es wird ein Halogenid eines III-Hauptgruppenelementes bereitgestellt, bspw. GaCl₄. Das Substrat wird auf eine Substrattemperatur aufgeheizt, die geringer ist als die Zerlegungstemperatur der zuvor mit Hydriden bezeichneten Verbindungen, die ein Element der V-Hauptgruppe aufweisen. Die Substrattemperatur ist darüber hinaus auch niedriger als die Zerlegungstemperatur eines aus diesem Hydrid gebildeten Radikals, aber ausreichend hoch, dass Atome des III-Hauptgruppenelementes und des V-Hauptgruppenelementes in kristalliner Ordnung in die Oberfläche einer sich bildenden Schicht eingebaut werden, wobei die Substrattemperatur insbesondere in einem Bereich zwischen 300 °C und 475 °C liegt. Es wird ein Trägergasstrom aus einem inerten Trägergas erzeugt, welches N₂, Ar, He sein kann, aber kein H₂ sein soll. Das Hydrid und das Halogenid sowie daraus entstandene Zerfallsprodukte werden zur Oberfläche des Substrates transportiert. Dies erfolgt bevorzugt bei einem Totaldruck von maximal 300 mbar. Es wird eine III-V-Schicht abgeschieden oder eine aus gleichartigen Schichten bestehenden Schichtenfolgen. Die Schichtdicke soll mindestens 200 nm besitzen. Das Verfahren wird derart durchgeführt, da sich aus dem Hydrid Radikale bilden. Bei der Verwendung von NH₃ kann dies bspw. durch Aufspalten in NH₂ und H erfolgen. Bei der Verwendung von NH₂R kann dies durch die Abtrennung des organischen Restes R erfolgen. Die so ausgebildeten Radikale reagieren in einer ersten Reaktion exotherm mit dem Halogenid des III-Hauptgruppenelementes an der Oberfläche. Als Reaktionsprodukt entsteht ein Atom der V-Hauptgruppe und einer Atom des Elementes der III-Hauptgruppe. Die Atome verbleiben an der Oberfläche. In einer zweiten Reaktion reagieren die Radikale gleichzeitig zur ersten Reaktion durch Aufnahme der bei der ersten Reaktion freigewordenen Wärme endotherm.

Details der Erfindung werden nachfolgend anhand beigefügter Zeichnungen erläutert. Es zeigen:
- Fig.1: den Querschnitt durch einen CVD-Reaktor, wie er zum Abscheiden der Schichten verwendet werden kann;
- Fig. 2a: die elektrische Bandstruktur eines GeSn-Halbleiters mit einem Sn-Anteil von 8 %;
- Fig. 2b: die elektrische Bandstruktur eines GeSn-Halbleiters mit einem Sn-Anteil von 13 %;
- Fig. 3a: das Photolumineszenzspektrum einer GeSn-Halbleiterschicht mit einem Sn-Anteil von 8 %;
- Fig. 3b: das Photolumineszenzspektrum einer GeSn-Halbleiterschicht mit einem Sn-Anteil von 9, 6 %;
- Fig. 3c: das Photolumineszenzspektrum einer GeSn-Halbleiterschicht mit einem Sn-Anteil von 11,1 %;
- Fig. 3d: das Photolumineszenzspektrum einer GeSn-Halbleiterschicht mit einem Sn-Anteil von 12,6 %;
- Fig. 4: das Beispiel einer erfindungsgemäßen Schichtenfolge;
- Fig. 5: eine Darstellung gemäß Figur 1 betreffend die Abscheidung von GaN.

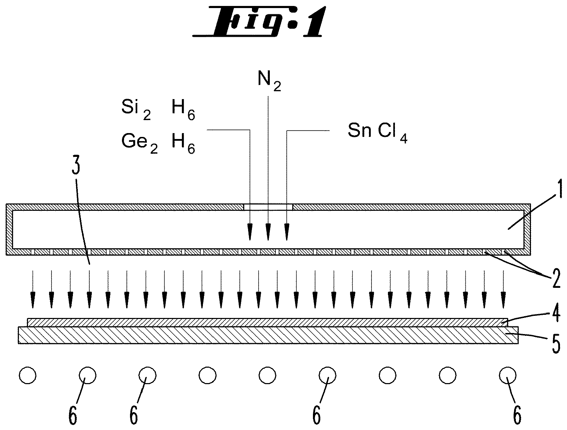

Die Figur 1 zeigt grob schematisch den Querschnitt durch einen CVD-Reaktor, wie er zur Durchführung des Verfahrens bzw. zum Abscheiden der Schichten der erfindungsgemäßen Bauelemente verwendet wird. Nicht dargestellt ist eine externe Gasversorgung zur Bereitstellung der Prozessgase, nämlich Si₂H₆ und Ge₂H₆ sowie SnCl₄ und als Inertgas N₂. Der Reaktor besitzt ein gasdicht nach außen verschlossenes Gehäuse, dessen Inneres mittels einer Vakuumeinrichtung evakuierbar bzw. auf einen Totaldruck im Bereich von 0 mbar bis 1.000 mbar regelbar ist. Innerhalb des Reaktorgehäuses befindet sich ein Gaseinlassorgan 1 in Form eines Showerheads. Es handelt sich dabei um eine Gasverteilkammer, die mit den Prozessgasen und dem Inertgas gespeist wird. Die Figur 1 zeigt ein Gaseinlassorgan 1 mit lediglich einem Gasverteilvolumen. Es ist aber auch vorgesehen, dass die drei Prozessgase getrennt voneinander durch jeweils eine Gasverteilkammer in eine unterhalb des Gaseinlassorgans 1 angeordnete Prozesskammer 3 eingeleitet werden. Dies erfolgt durch Gasaustrittsöffnungen 2 einer Gasaustrittsfläche des Gaseinlassorgans 1.

Der Boden der Prozesskammer 3 wird von einem Graphit-Suszeptor 5 ausgebildet, der etwa 1 cm bis 2 cm von der Gasaustrittsfläche entfernt ist. Auf dem Suszeptor 5 befinden sich ein oder mehrere Si-Substrate 4.

Unterhalb des Suszeptors 5 befindet sich eine Heizung 6, beispielsweise eine Lampenheizung, um den Suszeptor 5 auf eine Prozesstemperatur von beispielsweise 300 °C bis 400 °C aufzuheizen.

Es werden beispielhaft vier Experimente erläutert, um das Wesen der Erfindung zu erklären. Es werden beispielshaft vier Experimente erläutert, um das Wesen der Erfindung zu erklären. Die Wachstumsparameter der vier Schichten A, B, C, D sind der nachfolgend eingeblendeten Tabelle zu entnehmen.

| | x_S n (at. %) | Gesamtfluss (sccm) | Reaktordruck (mbar) | Temperatur (°C) | Ge₂ H₆-F luss (scc m) | SnCl₄-Fluss (sccm) | SnCl₄ bubbler Temperatur (°C) | Wachstumszeit (min) | Dampf druck SnCl₄ (mbar) |
|---|---|---|---|---|---|---|---|---|---|
| A | 8 | 2000 | 60 | 390 | 400 | 25 | 20 | 3.75 | 25 |
| B | 9.6 | 2000 | 60 | 375 | 400 | 25 | 20 | 4.83 | 25 |
| C | 11.1 | 2000 | 60 | 375 | 400 | 25 | 20 | 6 | 25 |
| D | 12.6 | 2000 | 60 | 350 | 400 | 12 | 20 | 13.33 | 25 |

Als Trägergas wurde N₂ verwendet. Die SnCl₄ bubbler wurden allerdings mit H₂ als Trägergas betrieben, um gasförmiges SnCl₄ in den Reaktor zu leiten. Die Schichten A und C wurden scheinbar mit denselben Wachstumsparametern gefertigt. Zu berücksichtigen ist hier allerdings, dass aufgrund einer Drift in der CVD-Anlage, insbesondere in der SnCl₄-Quelle die tatsächlichen SnCl₄-Flüsse verschieden gewesen sind. Das Verdünnungsverhältnis von SnCl₄ im H₂-Trä-gergasfluss durch den bubbler liegt bei etwa 10 % und unterliegt einer Drift, die insbesondere vom Füllungsstand des flüssigen Ausgangsstoffes im Quellenbehälter abhängt.

Auf einem Si(001)-Substrat wurde zunächst eine Ge-Bufferschicht abgeschieden. Die Ge-Bufferschicht besitzt eine hochqualitative Oberfläche. Es handelt sich um eine defektarme Ge-Bufferschicht mit einer Oberflächenrauigkeit im Bereich von 0.25 nm. Das Abscheiden der Ge-Bufferschicht erfolgte durch Einleiten von Ge₂H₆ in die Prozesskammer.

Auf die Ge-Bufferschicht wurden bei einem Ge₂H₆-Fluss von 400 sccm und einem Gesamtfluss von 2.000 sccm bei einem Totaldruck von 60 mbar in vier verschiedenen Experimenten Schichten aus Ge₁₋ₓSnₓ abgeschieden, wobei der Sn-Anteil 8 %, 9,6 %, 11,1 % bzw. 12, 6% betrug. Das Abscheiden erfolgte bei verschiedenen Temperaturen, wobei die Wachstumstemperatur einen Einfluss auf den Sn-Einbau besitzt. Die Wachstumsraten variieren zwischen 17 nm/min und 49 nm/min. Es wurden Schichten in einer Dicke von etwa 200 nm abgeschieden.

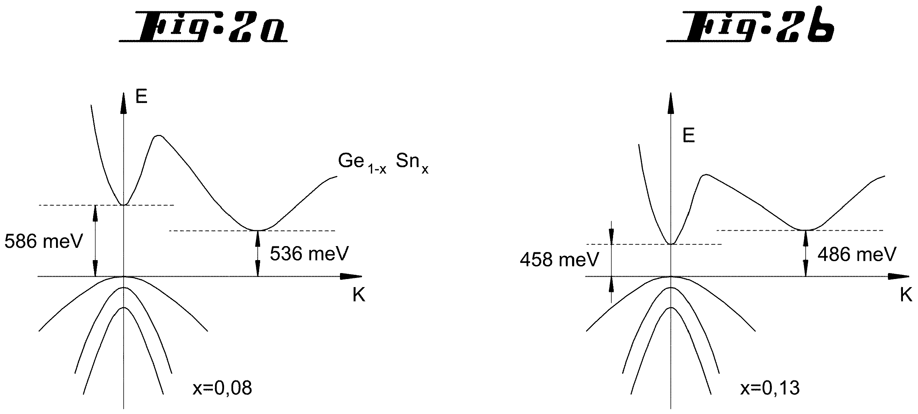

Die Figuren 2a und 2b zeigen die Bandstruktur eines Ge₁₋ₓSnₓ-Kristalls, wobei die Figur 2a die Bandstruktur eines Kristalls mit einem Sn-Anteil von 8 % und die Figur 2b die Bandstruktur mit einem Sn-Anteil von 13 % zeigt. Die Figur 2a zeigt, dass die direkte Bandlücke (Γ-Valley) eine größere Energie besitzt als die indirekte Bandlücke (L-Valley). Mit zunehmender Steigerung des Sn-Anteils verschieben sich sowohl die indirekte Bandlücke (L-Valley) als auch die direkte Bandlücke (Γ-Valley) zu niedrigeren Energien, wobei die Energie der Bandlücke des direkten Bandübergangs stärker absinkt, so dass in einem Bereich zwischen 8 % Sn-Anteil und 13 % Sn-Anteil der Bandübergang vom indirekten zum direkten wechselt. Da die Bandstruktur nicht nur vom Sn-Anteil, sondern auch von den Gitterverspannungen abhängt, lässt sich ein kritischer Sn-Anteil nicht angeben.

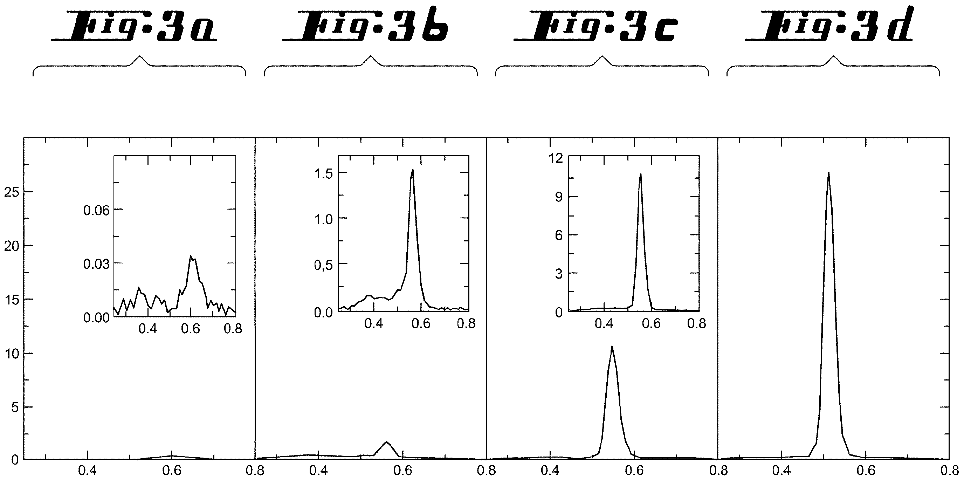

Die Figuren 3a bis 3d zeigen die Photolumineszenzspektren von Schichten mit voneinander verschiedenen Sn-Anteilen. Es ist erkennbar, dass die Schicht A mit einem Sn-Anteil von 8 % nur eine geringe Photolumineszenz, die Schicht B mit einem Sn-Anteil von 9, 6 % bereits eine erkennbare Photolumineszenz, die Schicht C mit einem Sn-Anteil von 11, 1 % eine deutliche Photolumineszenz und die Schicht D mit einem Sn-Anteil von 12,6 % eine starke Photolumineszenz jeweils bei 20° K zeigen.

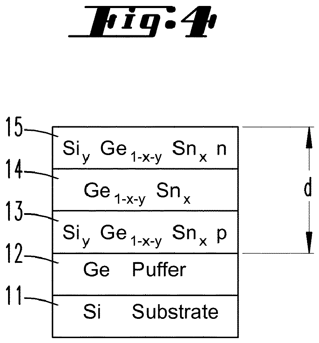

Die Figur 4 zeigt das Beispiel einer lichtemittierenden Schichtstruktur bestehend aus einer Schichtenfolge 13, 14, 15 mit einer Schichtdicke von mindestens 200 nm. Aus der in Figur 4 dargestellten Schichtenfolge kann beispielsweise ein Laser-Bauelement hergestellt werden, welches monolithisch in einen Schaltkreis integrierbar ist, der monolithisch auf ein Silizium-Substrat 11 aufgebracht worden ist. Auf ein Silizium-Substrat 11 wird zunächst eine Ge-Bufferschicht 12 abgeschieden. Auf die Ge-Bufferschicht 12 dann die erste Schicht SiGeSn 13 der Schichtenfolge, die p-dotiert ist, abgeschieden. Darauf wird eine aktive GeSn-Schicht 14 abgeschieden. Schließlich wird auf die aktive Schicht 14 eine n-dotierte SiGeSn-Schicht 15 abgeschieden. Der Sn-Anteil (x-Wert) liegt im Bereich zwischen 0,1 und 0,14. Der Si-Anteil (y-Wert) liegt im Bereich zwischen 0 und 0,2.

Bei dem Verfahren werden Ge₂H₆ aus einem Vorratsbehälter bei einem Druck über 1.000 mbar zusammen mit N₂ in das Gaseinlassorgan 1 eingespeist. Ge₂H₆ und Ge H₃* liegen gemäß folgender Gleichgewichtsreaktion im thermodynamischen Gleichgewicht.

Ge₂H₆ → 2GeH₃*

Während im Vorratsbehälter die linke Seite der Gleichgewichtsreaktion dominiert, wird das Verfahren so geführt, dass in der Prozesskammer die rechte Seite der Gleichgewichtsreaktion dominiert. Die Zerlegung von G₂H₆ in GeH₃* erfolgt aufgrund einer pneumatischen Expansion des Gases von einem Druck oberhalb Atmosphärendruck zu einem Sub-Atmosphärendruck. Im Ausführungsbeispiel erfolgt die Expansion nach 60 mbar.

Des Weiteren wird SnCl₄ in die Prozesskammer eingeleitet. Mit N₂ als Trägergas wird SnCl₄ und GeH₃* zur Oberfläche des Substrates 4 gefördert, welches auf dem beheizten Suszeptor 5 liegt und eine Oberflächentemperatur zwischen 350 °C und 390 °C besitzt. SnCl₄ und GeH₃* adsorbieren an der Oberfläche und reagieren dort exotherm miteinander.

4GeH₃* + 3SnCl₄ → 4Ge + 3Sn + 12HCl + Energie

Das bei dieser Reaktion entstehende HCl wird vom Trägergas aus der Prozesskammer 3 gefördert. Die freiwerdende Energie führt zu einer lokalen Erwärmung der Oberfläche. Die Ge- und Sn-Atome bleiben an der Oberfläche adsorbiert.

Zufolge der lokalen Erhöhung der Temperatur der Oberfläche kann die folgende endotherme Zerlegungsreaktion stattfinden.

2GeH₃* + Energie → 2Ge + 3H₂

Parallel kann auch die folgende Zerlegungsreaktion von undissoziiertem Ge₂H₆ stattfinden.

Ge₂H₆ + Energie → 2Ge + 3H₂

Der dabei entstehende Wasserstoff wird vom Trägergas abtransportiert. Die Oberfläche wird lokal auf eine derartige Temperatur aufgeheizt, dass die

Ge- und Sn-Atome eine ausreichende Oberflächenmobilität besitzen, um einkristallin einen Kristall aufzubauen. Bei der Prozesstemperatur (350 °C bis 390 °C) besitzt der so abgeschiedene Kristall eine Kristallstruktur, die weit jenseits des thermodynamischen Gleichgewichtes liegt (anstelle eines Sn-Anteils von maximal 1 % kann der Sn-Anteil bis zu 20 % betragen).

Wird zusätzlich noch eine Si-Komponente mit in die Prozesskammer eingebracht, so erfolgt dies unter Verwendung von Si₂H₆ als Ausgangsstoff, der analog des zuvor beschriebenen Mechanismus in adsorbierte Si-Atome zerlegt wird.

Es werden Schichten mit folgender Zusammensetzung abgeschieden

Si_{y}Ge_{1-x-y}Snₓ

0,08 ≤ x ≤0,14
0 ≤ y ≤ 0,2

Die Schicht 14 oder Schichtenfolge 13, 14, 15 soll erfindungsgemäß eine Mindestschichtdicke d von mindestens 200 nm, bevorzugt mindestens 300 nm besitzen. Bei einer derartigen Schichtdicke, die mit Wachstumsraten von 15 nm/min bis 50 nm/min abgeschieden worden ist, liegt die Versetzungsdichte im Schichtvolumen, also oberhalb eines Grenzbereiches zur Bufferschicht 12 von einer Dicke von 10 nm bis 20 nm bei maximal 10⁵ cm⁻² bis 10⁶cm⁻². Im Grenzbereich, also in den ersten 10 nm bis 20 nm der Schicht bzw. Schichtenfolge kann die Versetzungsdichte durchaus höhere Werte annehmen. Schraubenförmige oder fadenförmige Versetzungen besitzen dort jedoch eine Maximaldichte von 5 x 10⁶cm⁻².

In einer Variante der Erfindung wird durch eine Niedertemperatur Epitaxie ein Elementhalbleiter, beispielsweise eine Diamantschicht, eine Siliziumschicht oder eine Germaniumschicht abgeschieden. Zum Abscheiden einer Diamantschicht reagieren CH₃* mit CCl₄ zu Diamant. Zum Abscheiden einer Siliziumschicht reagieren SiH₃* mit SiCl₄ zu Silizium und zum Abscheiden einer Germaniumschicht reagieren GeH₃* mit GeCl₄ zu Germanium.

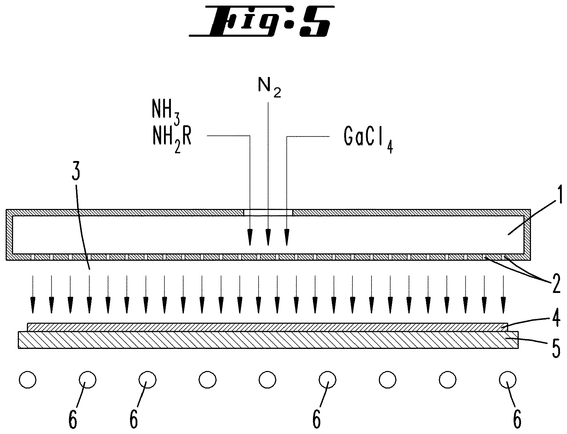

Unter Bezugnahme auf die Figur 5 wird im Folgenden ein weiteres Ausführungsbeispiel beschrieben, bei dem NH₃ aus einem Vorratsbehälter bei einem Druck von über 1000 mbar zusammen mit NH₂ in ein Gaseinlassorgan 1 eingespeist wird. Thermisch, aber auch mit anderen geeigneten Mitteln, bspw. einem Plasmagenerator oder anderweitiger Energieeinspeisung werden Radikale NH₂* nach der folgenden Reaktion hergestellt

NH₃ → NH₂* + H

Durch das Gaseinlassorgan 1 wird darüber hinaus GaCl₄ in die Prozesskammer eingespeist.

In einer Variante des Verfahrens wird anstelle von NH₃ NH₂R in die Prozesskammer eingespeist, da sich dieses Prozessgas mit weniger Energie in das Radikal NH₂* bringen lässt. R ist dabei ein organischer Rest, bspw. C₄H₉.

NH₂R → NH₂* + R

In einer ersten Reaktion reagiert das NH₂* exotherm mit Galliumchlorid nach der folgenden Reaktionsgleichung

2NH₂* + GaCl₄ → 2N + Ga + 4HCl + Energie

Die bei dieser Reaktion freiwerdende Energie betreibt die wie folgt angegebene Parallelreaktion

NH₂* + Energie → N + H₂,

bei der elementarer Stickstoff entsteht. Das sich bei der ersten exothermen Reaktion gebildete elementare Gallium und der bei der zweiten endothermen Reaktion gebildete elementare Stickstoff befindet sich an der Oberfläche. Die einzelnen Atome können die energetisch günstigsten Einbauplätze in die Schicht finden, so dass eine epitaktische monokristalline GaN-Schicht entsteht. Die Schicht kann auf einem Saphirsubstrat, einem Silliziumsubstrat oder einem III-V-Substrat abgeschieden werden.

Erfindungsgemäß erreichen die in der Gasphasenreaktion entstandenen Radikale die Oberfläche und reagieren erst dort miteinander.

Die vorstehenden Ausführungen dienen der Erläuterung der von der Anmeldung insgesamt erfassten Erfindungen, die den Stand der Technik zumindest durch die folgenden Merkmalskombinationen jeweils eigenständig weiterbilden, nämlich:
Ein Verfahren zum Abscheiden einer einkristallinen aus zumindest einem ersten Element A und einem zweiten Element B bestehenden Halbleiterschicht, wobei das erste Element A als Bestandteil eines ersten gasförmigen Ausgangsstoffs, insbesondere eines Hydrids, und das zweite Element B als Bestandteil eines zweiten gasförmigen Ausgangsstoffs, insbesondere eines Halogenids, zusammen mit einem von einem Inertgas gebildeten Trägergas, insbesondere N₂, Ar, He, in eine Prozesskammer 3 eines CVD-Reaktors eingespeist werden, wobei aus dem ersten Ausgangsstoff Radikale erzeugt werden, die Radikale und der zweite Ausgangsstoff zur Oberfläche eines auf eine Substrattemperatur aufgeheizten Halbleitersubstrat gebracht werden, welche niedriger ist als die Zerlegungstemperatur des reinen Radikals, wobei die Radikale in einer ersten Reaktion exotherm mit dem zweiten Ausgangsstoff, insbesondere dem Halogenid an der Oberfläche reagieren, wobei als Reaktionsprodukte Atome des ersten Elementes A und Atome des zweiten Elementes B an der Oberfläche bleiben und die Radikale in einer zweiten Reaktion gleichzeitig zur ersten Reaktion sich durch Aufnahme der bei der ersten Reaktion frei gewordenen Wärme endotherm zerlegen, wobei Atome des ersten Elementes A an der Oberfläche bleiben, wobei die Substrattemperatur ausreichend hoch ist, damit die Atome des ersten Elementes A und des zweiten Elementes B in kristalliner Ordnung in der Oberfläche eingebaut werden.

Ein Verfahren, das dadurch gekennzeichnet ist, dass das erste Element A ein Element der V-Hauptgruppe, beispielsweise Arsen, Phosphor, Antimon oder Stickstoff ist, das zweite Element B ein Element der III-Hauptgruppe, beispielsweise Aluminium, Gallium oder Indium ist, oder dass das erste Element ein Element der IV-Hauptgruppe, beispielsweise Kohlenstoff, Silizium oder Germanium ist und das zweite Element (B) ein Element der IV-Haupt-gruppe, beispielsweise Kohlenstoff, Silizium, Germanium oder Zinn ist, oder dass das erste Element (A) ein Element der VI-Hauptgruppe und das zweite Element (B) ein Element der II-Hauptgruppe ist.

Ein Verfahren, das dadurch gekennzeichnet ist, dass die Radikale durch pneumatisches Entspannen des ersten gasförmigen Ausgangsstoffs beim Einspeisen in die Prozesskammer von einem Druck größer als 1.000 mbar in einen Prozesskammerdruck von weniger als 300 mbar erzeugt werden.

Ein Verfahren zum monolithischen Abscheiden einer einkristallinen, bei Anregung leuchtenden, aus mehreren Elementen der IV-Hauptgruppe bestehende IV-IV-Schicht, insbesondere einer GeSn oder SiGeSn Schicht mit einer Versetzungsdichte kleiner 10⁶ cm⁻² auf einem IV-Substrat, insbesondere einem Silizium- oder Germanium-Substrat mit folgenden Schritten:
- Bereitstellen eines Hydrids eines ersten IV-Elementes A beispielsweise Ge₂H₆ oder Si₂H₆;
- Bereitstellen eines Halogenids eines zweiten IV-Elementes B beispielsweise SnCl₄;
- Aufheizen des Substrates auf eine Substrattemperatur, die geringer ist als die Zerlegungstemperatur des reinen Hydrids oder eines daraus gebildeten Radikals und ausreichend hoch ist, dass Atome des ersten Elementes A und des zweiten Elementes B in kristalliner Ordnung in die Oberfläche eingebaut werden, wobei die Substrattemperatur insbesondere in einem Bereich zwischen 300 °C und 475 °C liegt;

- Erzeugen eines Trägergasstroms aus einem inerten Trägergas, insbesondere N₂, Ar, He, welches insbesondere kein H₂ ist;
- Transportieren des Hydrids und des Halogenids sowie daraus entstandene Zerfallsprodukte zur Oberfläche bei einem Totaldruck von maximal 300 mbar;
- Abscheiden der IV-IV-Schicht oder einer aus gleichartigen IV-IV-Schichten bestehende Schichtenfolge mit einer Dicke von mindestens 200 nm, wobei die abgeschiedene Schicht insbesondere eine Si_{y}Ge_{1-x-y}Sn-Schicht ist, mit x > 0,08 und y ≤ 1.

Ein Verfahren, das dadurch gekennzeichnet ist, dass das Hydrid Ge₂H₆ und/ oder Si₂H₆ ist und mit einem Partialdruck von 60 Pa bis 120 Pa in die Prozesskammer eingespeist wird.

Ein Verfahren, das dadurch gekennzeichnet ist, dass das Halogenid SnCl₄ ist und mit einem Partialdruck von 0,1 % bis 5 % des Partialdrucks des Hydrids, insbesondere mit einem Partialdruck von 0,03 Pa bis 1,25 Pa in die Prozesskammer eingespeist wird.

Ein Verfahren, das dadurch gekennzeichnet ist, dass die Schicht oder die Schichtenfolge auf eine auf einem Si-Substrat aufgebrachte Ge-Bufferschicht abgeschieden wird.

Ein Verfahren, das dadurch gekennzeichnet ist, dass die Substrattemperatur in einem Bereich zwischen 350 °C und 390 °C liegt.

Ein Verfahren, das dadurch gekennzeichnet ist, dass das Abscheiden der Schicht oder Schichtenfolge mit einer Wachstumsrate im Bereich zwischen 15 nm/min und 50 nm/min erfolgt.

Optoelektronisches Bauelement, beispielsweise Laser, Fotodiode, Fotosensor, Fotoelement, Lichtleiter oder dergleichen mit einer auf einem IV-Substrat, insbesondere einem Ge- oder Si-Substrat epitaktisch abgeschiedenen, einkristallinen, bei Anregung leuchtenden, aus einer Legierung mehrerer Elemente der IV-Hauptgruppe bestehenden IV-IV-Schicht, insbesondere GeSn- oder SiGeSn-Schicht, mit einer Versetzungsdichte kleiner 10⁶ cm⁻², wobei die Schicht oder eine die Schicht aufweisende aus mehreren gleichartigen IV-IV-Schichten bestehende Schichtenfolge mindestens 200 nm, bevorzugt mindestens 300 nm, dick ist.

Ein Verfahren oder ein optoelektronisches Bauelement, welche dadurch gekennzeichnet sind, dass die Schicht eine GeSn- oder eine SiGeSn-Schicht ist und der Sn-Anteil im Bereich zwischen 8 % und 20 %, bevorzugt größer als 10 % und besonders bevorzugt im Bereich zwischen 10 % und 14 % liegt.

Ein Verfahren oder ein optoelektronisches Bauelement, welche dadurch gekennzeichnet sind, dass die Schicht einen Relaxationsgrad von größer 80 % besitzt und/ oder die Versetzungsdichte kleiner als 10⁵ cm² ist und/oder dass sich die Gitterfehlstellen auf einen Bereich nahe der Grenzschicht zum Substrat bzw. zur Bufferschicht, insbesondere auf einen Bereich von 10 nm bis 20 nm angrenzend an die Grenzschicht, beschränken.

Ein Verfahren oder ein optoelektronisches Bauelement, welche dadurch gekennzeichnet sind, dass die Schichtenfolge eine GeSn-Schicht ist, die zwischen zwei SiGeSn-Schichten angeordnet ist.

Eine Monolitisch aufgebrachte integrierte Schaltung, insbesondere Mikroprozessor, die gekennzeichnet ist durch ein monolithisch auf das Substrat oder eine Bufferschicht aufgebrachtes optoelektronisches Bauelement gemäß einem der Ansprüche 10 bis 13.

Alle offenbarten Merkmale sind (für sich, aber auch in Kombination untereinander) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen. Die Unteransprüche charakterisieren mit ihren Merkmalen eigenständige erfinderische Weiterbildungen des Standes der Technik, insbesondere um auf Basis dieser Ansprüche Teilanmeldungen vorzunehmen.

### Bezugszeichenliste

- 1: Gaseinlassorgan
- 2: Gasaustrittsöffnung
- 3: Prozesskammer
- 4: Substrat
- 5: Suszeptor
- 6: Heizung
- 7: ----------
- 8: ----------
- 9: ----------
- 10: ----------

- 11: Silizium-Substrat
- 12: Ge-Bufferschicht
- 13: Schichtenfolge
- 14: Schichtenfolge
- 15: Schichtenfolge

- d: Schichtdicke

## Patentansprüche

1. Verfahren zum Abscheiden einer einkristallinen aus zumindest einem ersten Element (A) und einem zweiten Element (B) bestehenden Halbleiterschicht, wobei das erste Element (A) als Bestandteil eines ersten gasförmigen Ausgangsstoffs, insbesondere eines Hydrids, und das zweite Element (B) als Bestandteil eines zweiten gasförmigen Ausgangsstoffs, insbesondere eines Halogenids, zusammen mit einem von einem Inertgas gebildeten Trägergas, insbesondere N₂, Ar, He, in eine Prozesskammer (3) eines CVD-Reaktors eingespeist werden, wobei aus dem ersten Ausgangsstoff Radikale erzeugt werden, die Radikale und der zweite Ausgangsstoff zur Oberfläche eines auf eine Substrattemperatur aufgeheizten Halbleitersubstrat gebracht werden, welche niedriger ist als die Zerlegungstemperatur des reinen Radikals, wobei die Radikale in einer ersten Reaktion exotherm mit dem zweiten Ausgangsstoff, insbesondere dem Halogenid an der Oberfläche reagieren, wobei als Reaktionsprodukte Atome des ersten Elementes (A) und Atome des zweiten Elementes (B) an der Oberfläche bleiben und die Radikale in einer zweiten Reaktion gleichzeitig zur ersten Reaktion sich durch Aufnahme der bei der ersten Reaktion frei gewordenen Wärme endotherm zerlegen, wobei Atome des ersten Elementes (A) an der Oberfläche bleiben, wobei die Substrattemperatur ausreichend hoch ist, damit die Atome des ersten Elementes (A) und des zweiten Elementes (B) in kristalliner Ordnung in der Oberfläche eingebaut werden.

2. Verfahren nach Anspruch 1, **dadurch gekennzeichnet, dass** das erste Element (A) ein Element der V-Hauptgruppe, beispielsweise Arsen, Phosphor, Antimon oder Stickstoff ist, das zweite Element (B) ein Element der III-Hauptgruppe, beispielsweise Aluminium, Gallium oder Indium ist.

3. Verfahren nach Anspruch 1, **dadurch gekennzeichnet, dass** das erste Element ein Element der IV-Hauptgruppe, beispielsweise Kohlenstoff, Silizium oder Germanium ist und das zweite Element (B) ein Element der IV-Hauptgruppe, beispielsweise Kohlenstoff, Silizium, Germanium oder Zinn ist.

4. Verfahren nach Anspruch 1, **dadurch gekennzeichnet, dass** das erste Element (A) ein Element der VI-Hauptgruppe und das zweite Element (B) ein Element der II-Hauptgruppe ist.

5. Verfahren nach einem der vorhergehenden Ansprüche, **dadurch gekennzeichnet, dass** die Radikale durch pneumatisches Entspannen des ersten gasförmigen Ausgangsstoffs beim Einspeisen in die Prozesskammer von einem Druck größer als 1.000 mbar in einen Prozesskammerdruck von weniger als 300 mbar erzeugt werden.

6. Verfahren nach Anspruch 3, **dadurch gekennzeichnet, dass** das Hydrid Ge₂H₆ und/oder Si₂H₆ ist und mit einem Partialdruck von 60 Pa bis 120 Pa in die Prozesskammer eingespeist wird.

7. Verfahren nach einem der Ansprüche 3 oder 6, **dadurch gekennzeichnet, dass** das Halogenid SnCl₄ ist und mit einem Partialdruck von 0,1 % bis 5 % des Partialdrucks des Hydrids, insbesondere mit einem Partialdruck von 0,03 Pa bis 1,25 Pa in die Prozesskammer eingespeist wird.

8. Verfahren nach einem der Ansprüche 3 oder 5 bis 7, **dadurch gekennzeichnet, dass** die Schicht oder die Schichtenfolge auf eine auf einem Si-Substrat aufgebrachte Ge-Bufferschicht abgeschieden wird.

9. Verfahren nach einem der Ansprüche 1 bis 8, **dadurch gekennzeichnet, dass** die Substrattemperatur in einem Bereich zwischen 350 °C und 390 °C liegt.

10. Verfahren nach einem der Ansprüche 1 bis 9, **dadurch gekennzeichnet, dass** das Abscheiden der Schicht oder Schichtenfolge mit einer Wachstumsrate im Bereich zwischen 15 nm/min und 50 nm/min erfolgt.

11. Optoelektronisches Bauelement, beispielsweise Laser, Fotodiode, Fotosensor, Fotoelement, Lichtleiter oder dergleichen mit einer auf einem IV-Substrat, insbesondere einem Ge- oder Si-Substrat epitaktisch abgeschiedenen, einkristallinen, bei Anregung leuchtenden, aus einer Legierung mehrerer Elemente der IV-Hauptgruppe bestehenden IV-IV-Schicht, insbesondere GeSn- oder SiGeSn-Schicht, mit einer Versetzungsdichte kleiner 10⁶ cm⁻², wobei die Schicht oder eine die Schicht aufweisende aus mehreren gleichartigen IV-IV-Schichten bestehende Schichtenfolge mindestens 200 nm, bevorzugt mindestens 300 nm, dick ist.

12. Verfahren nach einem der Ansprüche 3 oder 6 bis 10 oder optoelektronisches Bauelement nach Anspruch 11, **dadurch gekennzeichnet, dass** die Schicht eine GeSn- oder eine SiGeSn-Schicht ist und der Sn-Anteil im Bereich zwischen 8 % und 20 % liegt oder größer als 10 % ist.

13. Verfahren nach einem der Ansprüche 3, 6 bis 10 oder 12 oder optoelektronisches Bauelement nach Anspruch 11 oder 12, **dadurch gekennzeichnet, dass** die Schicht einen Relaxationsgrad von größer 80 % besitzt und/oder die Versetzungsdichte kleiner als 10⁵ cm⁻² ist und/ oder dass sich die Gitterfehlstellen auf einen Bereich nahe der Grenzschicht zum Substrat bzw. zur Bufferschicht, insbesondere auf einen Bereich von 10 nm bis 20 nm angrenzend an die Grenzschicht, beschränken.

14. Verfahren nach einem der Ansprüche 3, 6 bis 10, 12 oder 13 oder optoelektronisches Bauelement nach einem der Ansprüche 11 bis 13, **dadurch gekennzeichnet, dass** die Schichtenfolge eine GeSn-Schicht ist, die zwischen zwei SiGeSn-Schichten angeordnet ist.

15. Auf einem Substrat aufgebrachte integrierte Schaltung, insbesondere Mikroprozessor, **gekennzeichnet durch** ein monolithisch auf das Substrat oder eine in monolithischen Verbund mit dem Substrat stehenden Bufferschicht aufgebrachtes optoelektronisches Bauelement gemäß einem der Ansprüche 11 bis 14.
